# EUROPÄISCHE PATENTANMELDUNG

(11) **EP 4 203 631 A1**
(43) Veröffentlichungstag der Anmeldung: **28.06.2023**
(21) Anmeldenummer: 21216792.8
(22) Anmeldetag: 22.12.2021
(51) Int. Cl.: H05K 3/34, G01K 7/18, H01C 17/28, H01C 7/00

(54) **SMD-BAUTEIL MIT ABGESCHRÄGTEN KANTEN**

(71) Anmelder: Yageo Nexensos GmbH, 63801 Kleinostheim (DE)
(72) Erfinder: ASMUS, Tim, 35469 Allendorf-Winnen (DE); WIENAND, Karlheinz, 63741 Aschaffenburg (DE); BAUZ, Dennis, 63456 Hanau (DE); DIETMANN, Stefan, 63755 Alzenau (DE)
(74) Vertreter: Meissner Bolte Partnerschaft mbB

(57) **Zusammenfassung**

Die Erfindung betrifft ein oberflächenmontierbares Bauelement aufweisend einen elektrisch isolierenden Grundkörper , wobei auf einer ersten Fläche des Grundkörpers eine Leiterstruktur angeordnet ist, wobei die Leiterstruktur zwischen einer ersten Kante und einer gegenüberliegenden zweiten Kante der ersten Fläche angeordnet ist, wobei mindestens eine der Kanten zwischen der ersten Fläche und einer Kantenfläche ausgebildet ist, dadurch gekennzeichnet, dass die Kantenfläche und die Fläche einen Winkel (alpha) von mehr als 90° einschließen.

## Beschreibung

Die Erfindung betrifft ein oberflächenmontierbares Bauelement aufweisend einen Grundkörper, wobei auf dem Grundkörper eine Leiterstruktur angeordnet ist, und wobei der Grundkörper mindestens eine abgeschrägte Kante aufweist, sowie ein Verfahren zu dessen Herstellung und eine elektronische Baugruppe enthaltend das oberflächenmontierbare Bauelement.

Oberflächenmontierte Bauteile (engl. *surface mounted devices*) stellen eine Gruppe von elektrischen oder elektronischen Bauteilen in der Aufbau- und Verbindungstechnik dar, die ohne Verwendung von Drähten und Kabeln auf Substraten wie z.B. Leiterplatten befestigt werden. Durch diese Art des Verbindungsaufbaus können sehr kleine und kompakte Strukturen aufgebaut werden.

Aus dem Stand der Technik sind SMD-Temperatursensoren bekannt, die für die Flip-Chip-Montage geeignet sind. Die US5896081 beschreibt einen Prozess zur Herstellung von *surface-mounted* RTDs. Auf der Oberseite eines Nutzens werden die einzelnen Sensorstrukturen aufgebracht. Die Sensorstrukturen weisen an gegenüberliegenden Enden Kontaktpads auf. An der Unterseite des Nutzens werden ebenfalls Kontaktpads aufgebracht, die genau unter den Kontaktpads der Oberseite positioniert sind. Anschließend werden aus dem Nutzen zunächst einzelne Streifen parallel zueinander angeordneter Sensoren abgetrennt deren Stirnflächen anschließend durch Sputtern metallisiert werden. So wird eine elektrische Verbindung zwischen dem Kontaktpads der Sensorstruktur auf der Oberseite mit den Kontaktpads der Unterseite geschaffen. Die EP2711971A1 beschreibt ein Verfahren zur Herstellung von SMD-Bauelementen mit einer strukturierten Dünnschicht, wobei die strukturierte Dünnschicht auf unterschiedliche Flächen des Substrats aufgebracht werden kann. Somit ist die Anordnung der strukturierten Dünnschicht nicht auf ebene Flächen des Bauelements beschränkt. Diese bestehen aus einem isolierenden flachen Substrat und einer Edelmetall-Sensorstruktur mit zwei die Sensorstruktur abschließenden Kontaktpads. Die Edelmetallsensorstruktur ist typischerweise mit einer isolierenden Abdeckschicht versehen. Die beiden Kontaktpads sind üblicherweise an jeweils einem Längsende auf der Oberseite des Substrats angeordnet. Diese Flip-Chip-Sensoren lassen sich "kopfüber" mit einem PCB verbinden, indem die Zuleitungen auf dem PCB und die Kontaktpads der Sensoren z.B. mit einem Lot oder einer Sinterpaste elektrisch verbunden werden.

Alternativ können SMD-Temperatursensoren, die nicht als Flip-Chip konzipiert sind, an den Stirnflächen des Substrats metallisiert werden, um eine elektrische Verbindung zwischen den Kontaktpads der Oberseite und den der Unterseite des Substrats zu schaffen. Dazu werden die Sensoren an Ihren Stirnflächen in ein Metallbad getaucht. Dieser Prozess ist allerdings aufwendig, da aus einem Nutzen zunächst einzelne Streifen parallel zueinander angeordneter Sensoren abgetrennt werden müssen, um diese dann mit ihren Längskanten in ein metallisches Tauchbad zu führen. Wegen der geringen Breite der einzelnen Streifen - typischerweise 2 mm - 3 mm - und einer Eintauchtiefe von ca. 200 µm erfordert dieser Tauchbadprozess äußerste Präzision und ist daher aufwendig.

Ein weiterer Nachteil bei der Verwendung von SMD- Bauelementen in einer Flip-Chip-Konfiguration ist, dass sich die Qualität der elektrischen und mechanischen Verbindung nach dem Erzeugen der Verbindung nicht mehr visuell überprüfen lässt. Die Löt- oder Sinterverbindung findet sich unter dem SMD-Bauelement und wird durch das Substrat verdeckt. Schadhafte Fügestellen wie Risse, Kurzschlüsse oder mangelnde Benetzung können z.B. im Zuge einer Qualitätskontrolle nicht erkannt werden.

Es war eine Aufgabe der vorliegenden Erfindung mindestens einen Nachteil des Stands der Technik zu überwinden. Insbesondere war es eine Aufgabe der Erfindung ein oberflächenmontierbares Bauelement bereitzustellen, das eine optische Überprüfung der Verbindungsstelle zwischen dem elektrischen Kontakt auf einer elektrischen Baugruppe und der Metallisierung des SMD-Bauelements ermöglicht. Die elektrische Baugruppe kann z.B. ein PCB enthalten.

Insbesondere war es wünschenswert, dass sich im Fall einer Lötverbindung ein sichtbarer Lötminiskus zwischen den elektrischen Kontakten auf dem PCB und der Metallisierung des SMD-Bauelements ausbilden kann.

Die Aufgabe wird gelöst durch die Erfindung gemäß den unabhängigen Ansprüchen. Die Gegenstände der Unteransprüche stellen bevorzugte Ausführungsformen dar.

In einem ersten Aspekt betrifft die Erfindung ein oberflächenmontierbares Bauelement (1) aufweisend einen elektrisch isolierenden Grundkörper (10), wobei auf einer ersten Fläche (A) des Grundkörpers eine Leiterstruktur (20) angeordnet ist, wobei die Leiterstruktur (20) zwischen einer ersten Kante (16) und einer gegenüberliegenden zweiten Kante (16') der ersten Fläche angeordnet ist, wobei mindestens eine der Kanten (16, 16') zwischen der ersten Fläche (A) und einer Kantenfläche (11, 11') ausgebildet ist, dadurch gekennzeichnet, dass die Kantenfläche (11, 11') und die Fläche (A) einen Winkel (alpha) von mehr als 90° einschließen.

Die Erfindung betrifft ein oberflächenmontierbares Bauelement auch SMD-Bauelement (engl. *surface mounted device*) genannt. Ein SMD-Bauelement wird ohne Verwendung von Drähten und Kabeln direkt mit elektrischen Kontakten verbunden. Es wird zwischen dem elektrischen Kontakt und dem SMD- Bauelement typischerweise eine elektrische und mechanische Verbindung erzeugt. Oberflächenmontierbare Bauelemente können z.B. ausgewählt sein aus der Gruppe bestehend aus Widerständen, Sensoren, Kondensatoren und Induktivitäten. Die Sensoren sind vorzugsweise Temperatursensoren und ganz besonders Widerstandstemperatursensoren (RTD). Die Verbindung des oberflächenmontierbaren Bauteils mit einem elektrischen Kontakt kann bevorzugt mittels Lötens, Klebens oder Sinterns hergestellt werden.

Das oberflächenmontierbare Bauelement enthält einen Grundkörper mit einer auf einer ersten Fläche angeordneten Leiterstruktur. Der Grundkörper weit vorzugsweise eine Länge im Bereich von 500 µm bis 5 µm auf. Zusätzlich kann der Grundkörper eine Breite im Bereich von 300 µm bis 3 mm auf. Die Höhe des Grundkörpers beträgt vorzugsweise 150 µm bis 1000 µm.

Grundkörper ist elektrisch isolierend und kann umgangssprachlich auch als elektrisch isolierendes Substrat bezeichnet werden.

Material des Grundkörpers ist vorzugsweise elektrische isolierend. Das elektrisch isolierende Material des Grundkörpers kann ausgewählt sein aus organischen und anorganischen Materialien. Organische Materialien können beispielsweise Polymer sein. Anorganische Materialien können beispielsweise Keramiken, Halbleiter, wie z.B. Silizium, und Gläser umfassen oder daraus bestehen. Die Keramiken können vorzugsweise ausgewählt sein aus der Gruppe enthaltend Oxidkeramiken, Nitridkeramiken, Carbidkeramiken, Silicidkeramiken oder Mischungen der vorgenannten Keramiken. In einer besonders bevorzugten Ausführung umfasst der Grundkörper Aluminiumoxid.

Vorzugsweise weist der Grundkörper eine erste ebene Fläche und eine zweite, der ersten Fläche gegenüberliegende Fläche auf, wobei die erste und die zweite parallel zueinander angeordnet sind. Die erste Fläche des Grundkörpers wird vorzugsweise durch zwei gegenüberliegende, insbesondere parallel verlaufende, Kanten begrenzt.

Besonders bevorzugt entspricht der Grundkörper im Wesentlichen einem Quader. Der Begriff "im Wesentlichen" bedeutet hier bezogen auf den Quader, dass der Grundkörper ausgehend von einem Quader geformt ist. Allerdings stehen nicht notwendiger Weise alle Kanten des Quaders bzw. des Grundkörpers rechtwinklig zueinander. Vielmehr können eine oder mehrere Kanten des Quaders bzw. des Grundkörpers, die an die erste Fläche angrenzen, abgeschrägt sein. Abgeschrägte Kanten weisen eine Kantenfläche auf. In einer anderen möglichen Ausgestaltung der Erfindung weisen die erste Fläche und die der ersten Fläche gegenüberliegende zweite Fläche eine Form mit fünf oder mehr Ecken auf. In einer bevorzugten Ausgestaltung der Erfindung kann der Grundkörper angrenzend an die erste Fläche mehrere abgeschrägte Kanten aufweisen. Auf diese Weise kann ein geometrischer Körper erhalten werden, der an einen Sargdeckel erinnert. In einer anderen möglichen Ausgestaltung der Erfindung weist die erste Fläche eine Form mit fünf oder mehr Ecken auf. Der Grundkörper ist vorzugsweise als Platte, insbesondere eine quaderförmige Platte ausgebildet. Der Grundkörper weist eine erste Fläche auf, auf der eine Leiterstruktur angeordnet ist.

Die erste Fläche ist insbesondere eben und vorzugsweise rechteckig. Die Leiterstruktur ist zwischen zwei gegenüberliegenden Kanten der ersten Fläche angeordnet. Mindestens eine dieser Kanten ist zwischen der ersten Fläche und einer Kantenfläche ausgebildet. Anders ausgedrückt die zwei Kanten begrenzen die erste Fläche, insbesondere auf gegenüberliegenden Seiten.

Eine Kantenfläche ist eine Fläche, die an die Kante angrenzt. In anderen Worten, die erste Fläche und eine Kantenfläche sind die beiden angrenzenden Flächen zu einer Kante.

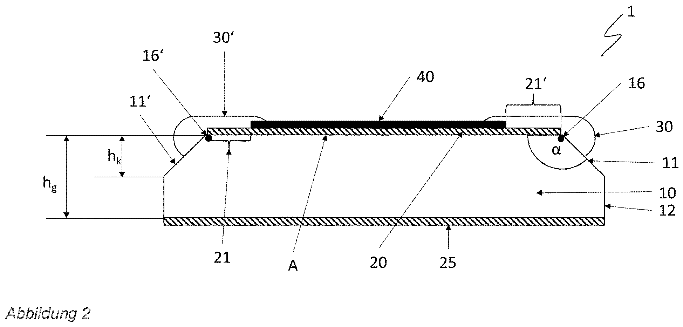

Die mindestens eine Kantenfläche und die erste Fläche schließen einen Winkel (alpha) von mehr als 90° ein. Der Winkel (alpha) gib den Winkel an, den die beiden Flächen innerhalb des Grundkörpers einschließen. Zur Veranschaulichung des Winkels (alpha) wird auf Abbildung 2 verwiesen. Vorzugsweise schließen die erste Fläche, auf der sich die Leiterstruktur befindet und mindestens eine Kantenfläche einen Winkel α ein, der im Bereich von 100° - 160° liegt.

In einer weiteren bevorzugten Ausführung schließen zwei Kantenflächen relativ zur ersten Fläche jeweils einen Winkel von mehr als 90°ein. In diesem Fall können die Kantenflächen symmetrisch oder asymmetrisch relativ zur ersten Fläche angeordnet sein. Besonders bevorzugt sind die Kantenflächen symmetrisch zur ersten Fläche angeordnet.

Die mindestens eine Kantenfläche erstreckt sich in ihrer Höhe hₖ vorzugsweise im Mittel über 20% - 80% der Höhe h_{g} des Grundkörpers. In diesem Zusammenhang wird auf Abbildung 2 verwiesen, die die beiden Höhen bespielhaft veranschaulicht.

Alternativ kann der Grundkörper des oberflächenmontierbaren Bauelements so beschrieben werden, dass er aus zwei aufeinander angeordneten Teilelementen besteht, wobei das untere der Teilelemente ein Quader ist und das obere der Teilelemente ein Prisma mit trapezförmigen Seitenflächen. Die erste Fläche ist auf dem prismatischen Teilelement angeordnet. Optional ist die mindestens eine Kantenfläche eben, gekrümmt, unregelmäßig grob strukturiert oder gestuft ausgeführt. In einer optionalen Ausführung kann die Kante zusammen mit der Kantenfläche als abgeschrägte Kante bezeichnet werden. In einer anderen möglichen Ausführungsform sind nicht nur die Kanten des Grundkörpers abgeschrägt zwischen denen sich die Leiterstruktur erstreckt, sondern auch mindestens eine weitere Kante, die die erste Fläche begrenzt.

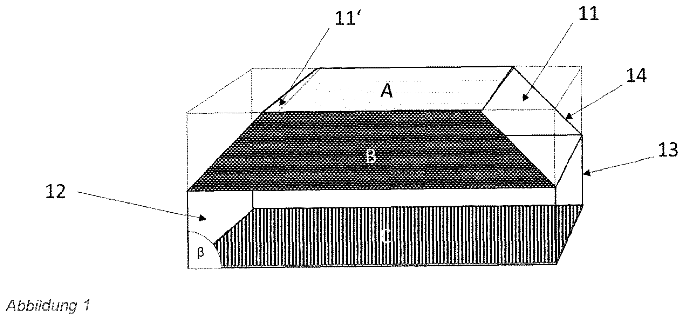

Vorzugsweise grenzt die mindestens eine Kantenfläche an eine weitere Fläche an, die senkrecht zur ersten Fläche orientiert ist. Vorzugsweise schließen diese eine weitere Fläche und die Fläche, die der ersten Fläche gegenüber liegt, einen Winkel (beta) von 90° ein. Der Winkel (beta) ist in Abbildung 1 beispielhaft dargestellt.

Auf einer ersten Fläche des Grundkörpers ist eine leitfähige Struktur angeordnet. Für den bevorzugten Fall, dass der Grundkörper im Wesentlichen einer Platte entspricht, kann die erste Fläche des Grundkörpers bevorzugt eine der Hauptflächen sein. Die Hauptflächen sind vorzugsweise die Flächen des Grundkörpers, die den größten Flächeninhalt aufweisen.

Die Leiterstruktur kann bevorzugt eine Sensorstruktur sein. Die Sensorstruktur kann eine Dünnschicht- oder eine Dickschichtstruktur sein. Insbesondere weist die Leiterstruktur ein Metall auf, das ausgewählt ist aus der Gruppe umfassend Edelmetalle, Kupfer, Aluminium sowie Kombinationen daraus oder die Leiterstruktur besteht aus dem Metall. Zur Klarstellung sei erwähnt, dass das Metall auch Legierungen umfasst. Vorzugsweise ist das Edelmetall ausgewählt aus Platin und Silber.

Die Leiterstruktur kann beispielsweise eine gewickelte Struktur oder eine Mäanderstruktur umfassen. In eine bevorzugten Ausführungsform weist die Leiterstruktur einen Nennwiderstand von 100 Ohm, 500 Ohm oder 1000 Ohm auf.

Gemäß dem ersten Aspekt der Erfindung ist die Leiterstruktur zwischen einer ersten Kante und einer gegenüberliegenden zweiten Kante der ersten Fläche angeordnet, wobei mindestens eine der Kanten zwischen der ersten Fläche und einer Kantenfläche ausgebildet ist. Insbesondere erstreckt sich die Leiterstruktur von der ersten Kante zur gegenüberliegenden zweiten Kante. In einer alternativen Ausführung kann die Leiterstruktur auch mit einem Abstand zur ersten Kante oder zur zweiten Kante angeordnet sein. Vorzugsweise ist die Leiterstruktur jedoch so nah an der ersten und /oder der zweiten Kante angeordnet, dass sie durch eine Metallisierung kontaktiert werden kann.

In einer bevorzugten Ausführungsform weist die Leiterstruktur Anschlusspads auf. Die Anschlusspads können Teil der Leiterstruktur sein oder getrennt von der Leiterstruktur hergestellt werden. In einem Beispiel weisen die getrennt hergestellten Anschlusspads ein Metall auf, das ausgewählt ist aus Silber, Gold, Palladium, Platin und Kupfer. Optional können die Anschlusspads eine Silberlegierung, z. B. AgPt oder AgPd aufweisen. Die Anschlusspads werden von mindestens einer Metallisierung kontaktiert. Die Metallisierung kann ein Edelmetall aufweisen, das insbesondere ausgewählt ist aus der Gruppe enthaltend Silber, Platin, Gold und Palladium. Die mindestens eine Metallisierung erstreckt sich vorzugsweise mindestens teilweise über mindestens eine Kantenfläche. Weiterhin bevorzugt umfasst die mindestens eine Metallisierung ein Dickschicht- oder Dünnschichtmaterial oder ist galvanisch aufgetragen. Ein Dickschichtmaterial wird typischer Weise durch Aufdrucken bzw. Dispensen und anschließendem Einbrennen einer Dickschichtpaste hergestellt. Die Dickschichtpaste umfasst leitfähige Metallpartikel und optional ein anorganisches Material wie z.B. Glas oder Keramik. Ein Dünnschichtmaterial wird üblicherweise mittels PVD (*physical vapordeposition*) aufgetragen. Die Metallisierung weist vorzugweise ein Metall auf, dass ausgewählt ist aus der Gruppe bestehend aus Zn, Ag, Pt, Cu, Bi und Pb.

In einer möglichen Ausführung ist die leitfähige Struktur zumindest teilweise mit einer Isolationsschicht bedeckt. Dies ist insbesondere dann der Fall, wenn das oberflächenmontierbare Bauelement in einer Flip-Chip-Konfiguration verwendet wird.

Auf einer zweiten Fläche des Grundkörpers, die der ersten Fläche gegenüber liegt, ist optional eine leitfähige Metallschicht zumindest bereichsweise angeordnet. Die leitfähige Metallschicht kann beispielsweise dazu dienen die Ankopplung, z.B. durch Sintern, zu verbessern und die thermische Leitfähigkeit zu erhöhen. Dies kann insbesondere in einer face-up-Konfiguration relevant sein, also, wenn die Leiterstruktur von einer Leiterplatte weg zeigt. Beispielsweise kann die leitfähige Metallschicht Silber, Kupfer oder Aluminium aufweisen.

In einem zweiten Aspekt betrifft die Erfindung ein Verfahren zur Herstellung eines oberflächenmontierbaren Bauelements aufweisend die Schritte:
a) Bereitstellen eines elektrisch isolierenden Substrats,
b) Aufbringen einer Leiterstruktur mit Anschlusspads auf dem elektrisch isolierenden Substrat,
c) Aufbringen von einer oder mehrerer Isolationsschichten auf der Leiterstruktur,
d) Einbringen mindestens einer Kerbe in das isolierende Substrat, sodass die mindestens eine Kerbe an mindestens ein Anschlusspad angrenzt,
e) Metallisieren der Anschlusspads optional bis in mindestens einen Teilbereich der mindestens einen Kerbe und
f) Vereinzeln der Leiterstruktur mindestens entlang der mindestens einen Kerbe in dem Substrat unter Erhalt eines oberflächenmontierbaren Bauelements.

Das Verfahren kann optional vor, zwischen oder nach den genannten Schritten weitere Schritte umfassen. Die Reihenfolge der Schritte a) bis f) wird jedoch vorzugsweise eingehalten.

In Schritt a) wird ein elektrisch isolierendes Substrat bereitgestellt. Das elektrisch isolierende Substrat kann auch als Nutzen bezeichnet werden. Vorzugsweise ist das elektrisch isolierende Substrat eine Platte. Die bevorzugte mittlere Dicke des isolierenden Substrats liegt im Bereich von 150 µm bis 1000 µm. Der Durchmesser bzw. die Kantenlänge des Substrats liegt vorzugsweise im Bereich von 2 Zoll bis 20 Zoll.

Das Material des elektrisch isolierenden Substrats kann ausgewählt sein aus organischen und anorganischen Materialien. Organische Materialien können beispielsweise Polymere sein. Anorganische Materialien können beispielsweise Keramiken, Halbleiter, wie z.B. Silizium, und Gläser umfassen. Die Keramiken können vorzugsweise ausgewählt sein aus der Gruppe enthaltend Oxidkeramiken, Nitridkeramiken, Carbidkeramiken, Silicidkeramiken oder Mischungen der vorgenannten Keramiken. Besonders bevorzugt enthält das elektrisch isolierende Substrat Aluminiumoxid, Siliziumoxid oder Zirkonoxid, beziehungsweise es besteht daraus.

Im nächsten Schritt b) erfolgt das Aufbringen einer Leiterstruktur mit Anschlusspads auf dem elektrisch isolierenden Substrat. Die Leiterstruktur kann bevorzugt ein Widerstand, eine Sensorstruktur, ein Transistor oder eine Induktivität sein. Vorzugsweise weist die Leiterstruktur ein Metall auf, wie es hierin beschrieben ist. Das Aufbringen der Leiterstruktur kann vorzugsweise mittels Druckens oder durch Aufbringen einer Metallschicht mit anschließender Strukturierung erfolgen. Das Drucken kann beispielsweise Siebdrucken und Inkjet-Drucken umfassen. Für den Fall, dass die leitfähige Struktur aus einer Metallschicht erzeugt wird, kann die Metallschicht mit Hilfe von Dünnschicht- oder Dickschichtverfahren hergestellt werden. Die Strukturierung der Metallschicht kann zum Beispiel mittels Laserablation, durch lithografische Verfahren oder Fräsen erfolgen.

Das Material der Leiterstruktur kann ein Material aufweisen oder daraus bestehen, so wie es im Abschnitt für das oberflächenmontierbare Bauelement beschrieben ist.

Vorzugsweise weist die Leiterstruktur Anschlusspads auf. Anschlusspads sind vorzugsweise Flächen der Leiterstruktur, die so ausgestaltet sind, dass sie von Anschlussdrähten oder anderen Leitern, z.B. von elektrischen Kontakten oder Metallisierungen, verlässlich kontaktiert werden können. Die Anschlusspads können Teil der Leiterstruktur sein oder getrennt aufgebracht werden. Getrennt aufgebrachte Anschlusspads können beispielsweise über galvanische Verfahren abgeschieden werden.

In Schritt c) erfolgt ein Aufbringen von einer oder mehrerer Isolationsschichten auf der Leiterstruktur. Hierbei werden die Anschlusspads, sofern vorhanden, vorzugsweise ausgenommen. Es ist auch möglich, dass die Anschlusspads erst mit einer Isolationsschicht bedeckt werden und anschließend wieder freigelegt werden.

Die Isolationsschicht kann ein Material umfassen oder aus einem Material bestehen, das ausgewählt ist aus isolierenden Polymeren, Gläsern, Glaskeramiken und Keramiken. Isolierende Polymere können beispielsweise Polyimide, Silikone, Parylene oder Epoxidharze sein. Isolationsschichten dienen vorzugsweise dazu die Leiterstruktur vor Umwelteinflüssen wie Feuchtigkeit oder Sauerstoff zu schützen.

Eine oder mehrere Isolationsschichten können mit Verfahren aufgebracht werden, die der Fachmann für elektrische und elektronische Bauteile für geeignet hält.

In Schritt d) erfolgt ein Einbringen mindestens einer Kerbe in das isolierende Substrat, sodass die mindestens eine Kerbe an mindestens ein Anschlusspad angrenzt. Das Angrenzen der Kerbe an ein Anschlusspad kann als direktes Angrenzen verstanden werden oder als Ausführungen bei dem ein Abstand einiger Mikrometer zwischen Kerbe und Anschlusspad vorliegt. Insbesondere ist die Kerbe so angeordnet, dass das mindestens eine Anschlusspad von einer Metallisierung kontaktiert werden kann. Bevorzugt wird die Kerbe entlang einer Reihe von Anschlusspads in das isolierende Substrat eingebracht. Besonders bevorzugt weist die Leiterstruktur mindestens zwei Anschlusspads auf und angrenzend an beide Anschlusspads wird jeweils eine Kerbe eingebracht. Das Einbringen mindestens einer Kerbe kann vorzugsweise mit einem Verfahren erfolgen, das ausgewählt ist aus der Gruppe bestehend aus Sägen, Fräsen und Laserablation. Die Laserablation kann besonders vorteilhaft mit einem Ultrakurzpulslaser durchgeführt werden. In einer bevorzugten Ausführung weist die Kerbe eine V-Form, insbesondere eine symmetrische V-Form auf. Der Winkel (alpha), den jede der Flächen der Kerbe mit der Oberfläche des isolierenden Substrats einschließt, liegt vorzugsweise im Bereich von 100° bis 160°. Die Breite der Kerbe an der breitesten Stelle liegt vorzugsweise im Bereich von 200 µm bis 2 mm. In einer möglichen Ausführung kann das Einbringen der Kerbe in einem oder in mehreren Schritten erfolgen. Die mittlere Tiefe der Kerbe am tiefsten Punkt beträgt vorzugsweise 20% bis 80% der Dicke des isolierenden Substrats. In einer möglichen Ausgestaltung ist das Substrat durch die Kerbe teilweise oder punktuell durchtrennt.

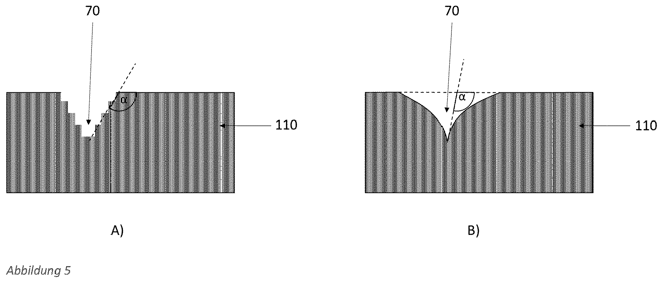

Für den Fall, dass die Kerbe abgerundet ist, bestimmt sich der Winkel zwischen der Flanke der Kerbe und der ersten Oberfläche aus der Steigung der Tangente am steilsten Punkt. In diesem Zusammenhang wird zur Veranschaulichung auf Abbildung 5 B) verwiesen.

Die Kerbe kann alternativ auch gestuft oder abgerundet ausgeführt sein. Für eine gestufte Ausführung der Kerbe ergibt sich der Winkel, den eine Fläche der Kerbe mit der Oberfläche einschließt aus der mittleren Steigung der Stufen (vgl. Abbildung 5 A). Für eine abgerundete Ausführung der Kerbe ergibt sich der Winkel (alpha) den eine Fläche der Kerbe mit der Oberfläche einschließt aus der größten Steigung der Tangente der Rundung. Optional können zusätzlich zu der Kerbe entlang eines Anschlusspads senkrecht dazu weitere Kerben in die Oberfläche des Substrats eingebracht werden. Diese sind so eingebracht, dass sie als abgeschrägte Kanten des resultierenden oberflächenmontierbaren Bauelements fungieren können.

Nach Schritt d) erfolgt in Schritt e) ein Metallisieren der Anschlusspads vorzugsweise mindestens bis in einen Teilbereich der mindestens einen Kerbe. Alternativ kann die Metallisierung der Anschlusspads vollständig oder teilweise außerhalb der Kerbe angeordnet werden. Optional kann sich die Metallisierung erst bei einer späteren thermischen Behandlung während der Herstellung einer elektrischen Baugruppe zumindest teilweise auf eine Kantenfläche erstrecken.

Das Metallisieren kann beispielsweise mittels Druckens, insbesondere mittels Siebdruckens erfolgen. Dabei erfolgt die Metallisierung so, dass die Anschlusspads kontaktiert werden. Vorzugsweise erfolgt dabei eine elektrische und eine mechanische Kontaktierung. Weiterhin erfolgt die Metallierung bis in einen Teilbereich der mindestens einen Kerbe. Mit anderen Worten, die Metallisierung wird vorzugsweise so angeordnet, dass sie sich im finalen oberflächenmontierbaren Bauelement auf mindestens einer Kantenfläche befindet.

In Schritt f) erfolgt ein Vereinzeln der Leiterstruktur unter Erhalt eines oberflächenmontierbaren Bauelements. Unter anderem erfolgt das Vereinzeln entlang der mindestens einen Kerbe in dem Substrat. Außerdem kann das Vereinzeln optional auch in Bereichen vorgenommen werden, in denen keine Kerbe vorliegt. Das Vereinzeln kann beispielsweise erfolgen durch Brechen, Laserschneiden, Sägen oder Fräsen.

Durch das Vereinzeln wird ein oberflächenmontierbares Bauelement erhalten, insbesondere ein oberflächenmontierbares Bauelement wie es im ersten Aspekt der Erfindung beschrieben ist.

In einer bevorzugten Ausführung wird das beschriebene Verfahren parallelisiert ausgeführt, so dass gleichzeitig mehre oberflächenmontierbare Bauelemente erhalten werden. Dazu werden insbesondere eine Vielzahl von Leiterstrukturen in Reihen und Spalten auf dem Substrat angeordnet und die nachfolgenden Schritte werden an allen Leiterstrukturen parallel durchgeführt. Dies erhöht den Produktionsdurchsatz.

In einem weiteren Aspekt betrifft die Erfindung eine elektrische Baugruppe aufweisend ein oberflächenmontierbares Bauelement gemäß der vorliegenden Erfindung und elektrische Kontakte, wobei mindestens ein elektrischer Kontakt über eine Lötverbindung mit einer der Metallisierungen auf dem oberflächenmontierbaren Bauelement verbunden ist. Vorzugsweise sind zwei oder mehr Metallisierungen des oberflächenmontierbaren Bauelements mit elektrischen Kontakten verbunden.

Die elektrische Baugruppe umfasst vorzugsweise auch elektronische Baugruppen. Die elektrische Baugruppe kann unteranderem eine Leiterplatte aufweisen, insbesondere eine gedruckte Leiterplatte (*engl. printed circuit board,* PCB). Auf der Leiterplatte können beispielsweise Schaltkreisen oder weitere elektrische bzw. elektronische Komponenten angeordnet sein.

Vorzugsweise weist die elektrische Baugruppe mindestens zwei elektrische Kontakte auf. Insbesondere sind die elektrischen Kontakte als Landepads ausgeführt. Als Landepads können Flächen eines elektrischen Kontakts insbesondere einer elektrischen Leiterbahn, bezeichnet werden, die geeignet sind ein oberflächenmontierbares Bauelement sicher zu kontaktieren. In einer bevorzugten Ausführung der Erfindung kann das oberflächenmontierbare Bauelement in einem automatisierten Bestückungsprozess auf der Oberfläche der elektrischen Baugruppe angeordnet werden. Mindestens ein elektrischer Kontakt der elektrischen Baugruppe ist über eine Lötverbindung mit einer der Metallisierungen auf dem oberflächenmontierbaren Bauelement verbunden. Vorzugsweise wird die Verbindung mittels Reflow-Lötens hergestellt. Dazu wird auf einem elektrischen Kontakt oder auf der Metallisierung eine Lötlegierung aufgetragen, bevor das oberflächenmontierbare Bauelement auf der elektrischen Baugruppe angeordnet wird. Die Lötlegierung kann mittels Schablonendruckes oder Dispensen einer Lotpaste, durch Lotformteile (engl. *preforms*) oder über galvanische Verfahren aufgetragen werden. Die Verwendung von Lotpaste hat den Vorteil, dass diese klebrig ist und so die oberflächenmontierbaren Bauelemente bei der Bestückung direkt an der Paste haften können. So müssen oberflächenmontierbare Bauelemente meist nicht zusätzlich fixiert werden, bevor sie verlötet werden. Alternativ oder zusätzlich kann das oberflächenmontierbare Bauelement auf andere Weise vorfixiert werden.

Die elektrische Baugruppe wird anschließend so stark erhitzt, dass das die Lötlegierung schmilzt. Gleichzeitig aktiviert die erhöhte Temperatur vorzugsweise das in einer Lotpaste enthallten Flussmittel. Ein Vorteil des Reflow-Lötens ist, dass die Oberflächenspannung der geschmolzenen Lotlegierung die Bauelemente auf die Mitte eines elektrischen Kontakts ziehen kann.

In einer bevorzugten Ausführung der elektrischen Baugruppe ist das oberflächenmontierbare Bauelement so auf der elektrischen Baugruppe angeordnet, dass die erste Fläche, auf der die leitfähige Struktur angeordnet ist, zur Oberfläche der Leiterplatte hin orientiert ist. Diese Konfiguration wird auch als face down-Konfiguration bezeichnet.

Die Lötverbindung bildet vorzugsweise einen sichtbaren Lötmeniskus zwischen dem elektrischen Kontakt und der Kantenfläche des oberflächenmontierbaren Bauelements.

Die Lötverbindung zwischen dem oberflächenmontierbaren Bauelement und dem elektrischen Kontakt ist an mindestens einer Seite sichtbar, da sie sich zumindest an der Kontaktfläche des oberflächenmontierbaren Bauelements befindet.

Durch die abgeschrägte Kante des Bauelements kann die Lötstelle besonders gut und einfach optisch inspiziert werden. Dies ist bei herkömmlichen Lötverbindungen, bei denen das flüssige Lot auf Grund von Kapillarwirkung unter die oberflächenmontierbaren Bauelemente gezogen wird nicht der Fall.

In einer weiteren bevorzugten Ausführung der elektrischen Baugruppe ist die erste Fläche des oberflächenmontierbaren Bauelements von den elektrischen Kontakten weg orientiert und die Leiterstruktur weist Anschlusspads auf, die von mindestens einer Metallisierung kontaktiert werden, wobei sich die Metallisierung von mindestens einem Anschlusspad bis zu mindestens einem elektrischen Kontakt der Baugruppe erstreckt. In dieser Ausführung ist das oberflächenmontierbare Bauelement in einer sogenannten face-up-Konfiguration angeordnet. Die Verbindung der Metallisierung mit einem elektrischen Kontakt kann vorzugsweise dadurch hergestellt werden, dass die Metallisierung beim Verbinden des oberflächenmontierbaren Bauelements mit den elektrischen Kontakten erwärmt wird und fließfähig wird. Diese fließfähige Metallisierung kann dann, getrieben durch die Schwerkraft, über die Kantenfläche hinabfließen und sich von der Leiterstruktur bis zu einem elektrischen Kontakt erstrecken. Dadurch kann ein elektrischer Kontakt zwischen der Leiterstruktur auf dem oberflächenmontierbaren Bauelement und dem elektrischen Kontakt der Baugruppe hergestellt werden. Ein Vorteil dieser Ausführung ist, dass für die elektrische Kontaktierung vorzugsweise keine weitere Lötverbindung notwendig ist. Auch eine Tauchbeschichtung der Kanten des oberflächenmontierbaren Bauteils kann so vermieden werden.

Im folgenden werden Ausführungsbeispiele der Erfindung anhand von Abbildungen näher erläutert. Dabei zeigen:
Abbildung 1 eine perspektivische Zeichnung eines im wesentlichen quaderförmigen Grundkörpers,
Abbildung 2 einen Querschnitt durch ein oberflächenmontierbares Bauelement,
Abbildung 3 eine schematische Darstellung einer elektrischen Baugruppe, bei dem ein oberflächenmontierbares Bauelement auf einer Leiterplatte angeordnet ist,
Abbildung 4 a) - f) einen möglichen Ablauf eines Verfahrens zur Herstellung eines oberflächenmontierbaren Bauelements,
Abbildungen 5 A und B zwei mögliche Ausführungsformen einer Kerbe im Substrat und
Abbildung 6 eine Skizze einer elektrische Baugruppe, bei der das oberflächenmontierbare Bauelement in *face-up*-Konfiguration angeordnet ist.

In Abbildung 1 ist ein elektrisch isolierender Grundkörper (10) eines oberflächenmontierbaren Bauelements gezeigt. Der Grundkörper (10) weist hier im Wesentlichen die Form eines Quaders auf. Der Grundkörper weist eine erste Fläche (A) und eine der ersten Fläche (A) gegenüberliegende Fläche (C) auf. Die Flächen (A) und (C) sind vorzugsweise parallel zueinander angeordnet. Auf der ersten Fläche (A) ist eine Leiterstruktur (20) angeordnet und auf der zweiten Fläche (C) kann optional eine leitfähige Metallschicht angeordnet sein (hier nicht gezeigt). An eine Kante der Fläche (A) grenzen die Kantenflächen (11,11') an. Die Kantenflächen (11, 11') schließen einen Winkel >90° mit der ersten Fläche (A) ein. In der Abbildung 1 ist zu erkennen, dass der Grundkörper (10) dadurch zwei abgeschrägte Kanten aufweist. Die gestrichelten Linien skizzieren den gedachten Verlauf eines vollständigen Quaders, der keine Kantenflächen bzw. abgeschrägten Kanten aufweist. Die Kantenflächen (11, 11') gehen wiederum in eine weitere Fläche (12, 12') über. Die weiteren Flächen (12, 12') und die zweite Fläche (C) schließen im hier gezeigten Beispiel einen Winkel β von 90° ein. Optional kann der Grundkörper (10) auch so beschrieben werden, dass er aus zwei Teilelementen (13) und (14) besteht. Das erste Teilelement (13) hat die Form eines Quaders. Auf dem ersten Teilelement (13) ist ein zweites Teilelement (14) angeordnet, das die Form eines Prismas aufweist, das wiederum eine trapezförmige Seitenfläche (B) aufweist. Vorzugsweise steht die trapezförmige Fläche (B) senkrecht zur ersten Fläche (A). Weiterhin bevorzugt weist der Grundkörper eine elektrisch isolierende Keramik auf oder besteht daraus.

In Abbildung 2 ist der Querschnitt durch ein oberflächenmontierbares Bauelement (1) dargestellt. Auf einem Grundkörper (10) ist eine Leiterstruktur (20) angeordnet. Die Leiterstruktur ist auf der ersten Fläche A des Grundkörpers angeordnet. Die Leiterstruktur erstreckt sich von einer ersten Kante (16) zu einer zweiten Kante (16'). In der Zeichnung sind die Kanten (16, 16') als Punkte dargestellt. Dies soll jedoch nur zur Illustration der Position der Kanten dienen und findet sich in physischen Produkten so nicht wieder. An die Kanten (16, 16') schließen sich die Kantenflächen (11 bzw. 11') an. Die Fläche (A), auf der sich die Leiterstruktur befindet und die Kantenflächen (11, 11') schließen einen Winkel α von mehr als 90° ein. An die Kantenfläche (11) schließt sich eine weitere Fläche (12) an. Diese steht vorzugsweise im rechten Winkel zur Fläche, auf der sich die Leiterstruktur (20) befindet. Der Grundkörper (10) weist eine Höhe h_{g} auf. Die Höhe hₖ der Kantenfläche (11, 11') erstreckt sich über 20% - 80% der Höhe h_{g}.

Die Leiterstruktur (20) in Abbildung 2 weist Anschlusspads (21, 21') auf. Diese Anschlusspads (21, 21') grenzen an die Kanten (16, 16') an. Auf der Leiterstruktur (20) befindet sich eine Isolationsschicht (40), die die Anschlusspads (21, 21') nicht bedeckt. Auf den Anschlusspads (21, 21') sind Metallisierungen (30, 30') angeordnet. Die Metallisierungen erstrecken sich optional teilweise über die Kantenflächen (11, 11'). In einer anderen, optionalen Ausgestaltung ist auf dem Grundkörper eine leitfähige Schicht (25) auf der Fläche angeordnet, die der Fläche mit der Leiterstruktur (20) gegenüberliegt. Die leitfähige Schicht (25) kann beispielsweise eine Metallschicht sein.

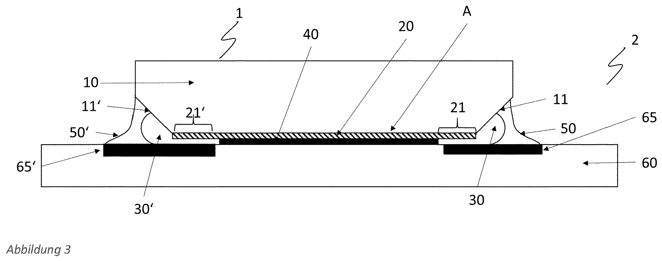

In Abbildung 3 ist ein Querschnitt durch ein elektrische Baugruppe (2) gezeigt, wobei die elektrische Baugruppe ein oberflächenmontierbares Bauelement (1) umfasst. Das oberflächenmontierbare Bauelement (1) ist auf elektrischen Kontakten (65, 65') angeordnet.

Die elektrischen Kontakte (65, 65') befinde sich auf einer Leiterplatte (60). Die Metallisierungen (30, 30') sind über Lötverbindungen (50, 50') mit den elektrischen Kontakten (65, 65') verbunden. Die Verbindung des oberflächenmontierbaren Bauelements (1) mit der Leiterplatte erfolgt also ohne Drähte oder Kabel. Dadurch, dass der Grundkörper (10) angrenzend an die erste Fläche (A) abgeschrägte Kanten mit den Kantenflächen (11, 11') aufweist, bildet das Lotmaterial der Lötverbindung (50, 50') einen Meniskus, der sich von der Oberfläche des elektrischen Kontakts (65, 65') bis zur Kantenfläche (11, 11') erstreckt. Dadurch können die Lötverbindungen (50, 50') einer visuellen Kontrolle unterzogen werden, z.B. auf Risse oder Lufteinschlüsse. Das oberflächenmontierbare Bauelement (1) ist in Abbildung 3 in Flip-Chip-Konfiguration auf der Leiterplatte (60) mit den elektrischen Kontakten (65, 65') angeordnet. Das bedeutet, dass die Leiterstruktur (20) auf dem Grundkörper (10) zur Leiterplatte (60) hin orientiert ist. Die Isolationsschicht (40) kann dafür sorgen, dass die Metallisierungen (30, 30') und / oder die Lötverbindungen (50, 50') die empfindliche Leiterstruktur (20) außerhalb der Anschlusspads (21, 21') nicht beschädigen.

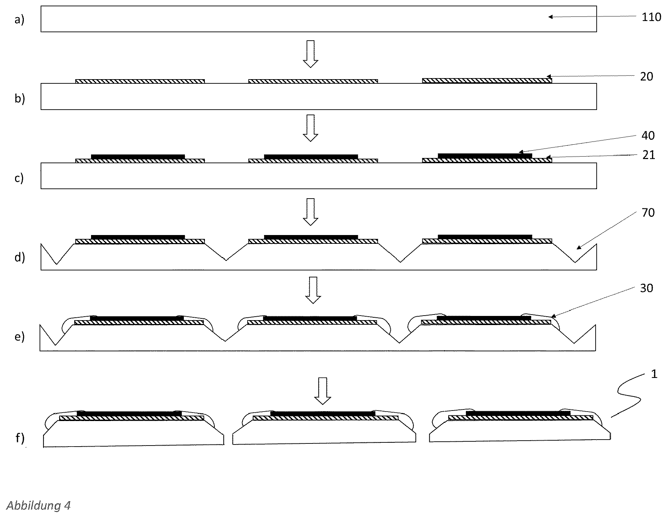

Abbildung 4 zeigt eine beispielhafte Ausführung des erfindungsgemäßen Verfahrens zur Herstellung eine oberflächenmontierbaren Bauelements. In Schritt 4 a) wird ein Substrat (110) bereitgestellt. In Schritt 4 b) werden Leiterstrukturen (20) auf das Substrat aufgebracht. In Schritt 4 c) folgt das Aufbringen von Isolationsschichten (40). Dies kann beispielsweise mittels Siebdrucks erfolgen. Die Teile der Leiterstruktur, die die Anschlusspads (21) darstellen, sind vorzugsweise frei von der Isolationsschicht. In Schritt 4 d) werden Kerben (70) in das Substrat eingebracht. Dies kann vorzugsweise durch Laserablation mit einem Ultrakurzpuls-Laser erfolgen. In Schritt 4 e) wird auf die Anschlusspads jeweils eine Metallisierung (30, 30') aufgetragen, die sich bis in die Kerben (70) erstreckt. Im gezeigten Fall reicht die Metallisierung (30, 30') bis auf einen Teil der Flächen der V-förmigen Kerben (70). Im Schritt 4 f) werden dann die parallelisiert hergestellten Leiterstrukturen (30) vereinzelt und dadurch mehrere oberflächenmontierbaren Bauelemente (1) erhalten. Das Vereinzeln kann zweckmäßig ebenfalls mittels Laserablation, bzw. Laserschneiden erfolgen.

In Abbildung 5 werden unterschiedliche Ausgestaltungen einer Kerbe 70 dargestellt. In Abbildung 5 A) ist eine gestuft ausgestaltete Kerbe (70) dargestellt. Die gestrichelten Linien zeigen die mittlere Steigung der Flanken der Kerbe an. Im gestuften Fall kann der Winkel (alpha) zwischen der Oberfläche des Substrats (110) und dieser mittleren Steigung bestimmt werden. In Abbildung 5 B) ist eine Kerbe (70) mit abgerundeten Flanken dargestellt. Der Winkel (alpha) ergibt sich hier aus der Tangente am Punkt der größten Steigung (hier am Fuß der Kerbe) und der Oberfläche des Substrats (110).

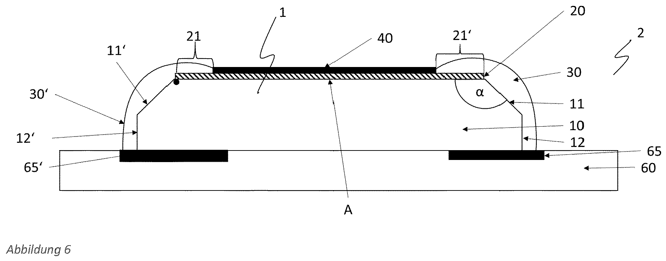

In Abbildung 6 ist eine elektrische Baugruppe (2) dargestellt, bei der die erste Fläche (A) des oberflächenmontierbaren Bauelements (1) von den elektrischen Kontakten (65, 65') weg orientiert ist. Die Leiterstruktur (20) weist Anschlusspads (21, 21') auf, die von einer Metallisierung (30, 30') kontaktiert werden. Die Metallisierung (30, 30') erstreckt sich von den Anschlusspads (21, 21') über die Kantenflächen (11, 11') und die weiteren Flächen (12, 12') bis zu den elektrischen Kontakten (65, 65'). Dadurch wird der elektrische Kontakt zwischen den Anschlusspads (21, 21') der Leiterstruktur (20) und den elektrischen Kontakten (65, 65') hergestellt, ohne, dass weitere Lötverbindungen erforderlich sind.

### Bezugszeichenliste

- (1): oberflächenmontierbares Bauelement
- (2): elektrische Baugruppe
- (10): Grundkörper
- (11, 11'): Kantenfläche
- (12, 12'): weitere Fläche
- (13): erstes Teilelement
- (14): zweites Teilelement
- (20): Leiterstruktur
- (21): Anschlusspads
- (30, 30'): Metallisierung
- (40): Isolationsschicht
- (50): Lotverbindung
- (60): Leiterplatte
- (65): elektrischer Kontakt
- (70): Kerbe
- (110): Substrat
- (A): erste Fläche
- (B): trapezförmige Seitenfläche
- (C): zweite Fläche
- (a, alpha): Winkel der von der ersten Fläche A und der Kantenfläche (11, 11') eingeschlossen ist
- (β, beta): Winkel der von der zweiten Fläche (12) und der zweiten Fläche (C) eingeschlossen ist

## Patentansprüche

1. Oberflächenmontierbares Bauelement (1) aufweisend einen elektrisch isolierenden Grundkörper (10), wobei auf einer ersten Fläche (A) des Grundkörpers eine Leiterstruktur (20) angeordnet ist, wobei die Leiterstruktur (20) zwischen einer ersten Kante (16) und einer gegenüberliegenden zweiten Kante (16') der ersten Fläche angeordnet ist, wobei mindestens eine der Kanten (16, 16') zwischen der ersten Fläche (A) und einer Kantenfläche (11, 11') ausgebildet ist, **dadurch gekennzeichnet, dass** die Kantenfläche (11, 11') und die Fläche (A) einen Winkel (alpha) von mehr als 90° einschließen.

2. Oberflächenmontierbares Bauelement gemäß Anspruch 1, wobei der Grundkörper im Wesentlichen einem Quader entspricht. F

3. Oberflächenmontierbares Bauelement gemäß einem der Ansprüche 1 oder 2, wobei die erste Fläche (A), auf der sich die Leiterstruktur (20) befindet und die Kantenfläche (11, 11') einen Winkel α einschließen, der im Bereich von 100° - 160° liegt.

4. Oberflächenmontierbares Bauelement gemäß einem der Ansprüche 1 - 3, wobei der Grundkörper zwei Kantenflächen aufweist und beide Kantenflächen (11, 11') relativ zur ersten Fläche (A) jeweils einen Winkel von mehr als 90°einschließen und die Kantenflächen symmetrisch oder asymmetrisch relativ zur ersten Fläche (A) angeordnet sind.

5. Oberflächenmontierbares Bauelement gemäß einem Ansprüche 1 - 4, wobei sich die Höhe hₖ mindestens eine abgeschrägte Kantenfläche (11, 11') im Mittel über 20% - 80% der Höhe h_{g} des Grundkörpers erstreckt.

6. Oberflächenmontierbares Bauelement gemäß einem Ansprüche 1 - 5, wobei die Leiterstruktur zumindest teilweise mit einer Isolationsschicht (40) bedeckt ist.

7. Oberflächenmontierbares Bauelement gemäß einem Ansprüche 1 - 6, wobei die Leiterstruktur (20) Anschlusspads (21, 21') aufweist, die von mindestens einer Metallisierung (30, 30') kontaktiert werden, wobei sich die Metallisierung (30, 30') mindestens teilweise über die mindestens eine Kantenfläche (11, 11') erstreckt.

8. Oberflächenmontierbares Bauelement (1) gemäß einem Ansprüche 1 - 7, wobei die mindestens eine Metallisierung (30, 30') eine Dünnschicht- oder Dickschichtmaterial umfasst oder galvanisch aufgetragen ist.

9. Oberflächenmontierbares Bauelement (1) gemäß einem der vorigen Ansprüche, wobei auf einer zweiten Fläche des Grundkörpers (10), die der Leiterstruktur (2) gegenüber liegt, eine leitfähige Metallschicht (25) zumindest bereichsweise angeordnet ist.

10. Verfahren zur Herstellung eines oberflächenmontierbaren Bauelements (1) aufweisend die Schritte:
a. Bereitstellen eines elektrisch isolierenden Substrats,
b. Aufbringen einer Leiterstruktur mit Anschlusspads auf dem elektrisch isolierenden Substrat,
c. Aufbringen von einer oder mehrerer Isolationsschichten auf der Leiterstruktur,
d. Einbringen mindestens einer Kerbe in das isolierende Substrat, sodass die mindestens eine Kerbe an mindestens ein Anschlusspad angrenzt,
e. Metallisieren der Anschlusspads, optional mindestens bis in einen Teilbereich der mindestens einen Kerbe und
f. Vereinzeln der Leiterstruktur entlang der mindestens einen Kerbe in dem Substrat unter Erhalt eines oberflächenmontierbaren Bauelements.

11. Verfahren gemäß Anspruch 10, wobei das Einbringen einer oder mehrerer Kerben mittels Sägens, Fräsens, Ätzens, Ritzens, Schneidens oder Laserablation erfolgt.

12. Verfahren gemäß Anspruch 10 oder 11, wobei das Aufbringen der Leiterstruktur mittels Siebdrucks oder durch Metallisierung mit anschließender Strukturierung erfolgt.

13. Elektrische Baugruppe aufweisend ein oberflächenmontierbares Bauelement gemäß Anspruch 1 - 9 und elektrische Kontakte, wobei mindestens ein elektrischer Kontakt über eine Lötverbindung mit einer der Metallisierungen (30, 30') auf dem oberflächenmontierbaren Bauelement verbunden ist.

14. Elektrische Baugruppe gemäß Anspruch 13, wobei das oberflächenmontierbare Bauelement auf einer Leiterplatte angeordnet ist.

15. Elektrische Baugruppe gemäß einem der Ansprüche 13 oder 14, wobei die Fläche (A) des Grundkörpers, auf der die leitfähige Struktur angeordnet ist, zur Oberfläche der Leiterplatte hin orientiert ist.

16. Elektrische Baugruppe gemäß einem der Ansprüche 13 -15, wobei sich die Lötverbindung zwischen der Kantenfläche des oberflächenmontierbaren Bauelement und dem elektrischen Kontakt erstreckt und im Bereich der abgeschrägten Kante als Lötmeniskus sichtbar ist.

17. Elektrische Baugruppe gemäß einem der Ansprüche 13 - 16, wobei die erste Fläche (A) des Grundkörpers (10) des oberflächenmontierbaren Bauelements (1) von den elektrischen Kontakten (65, 65') weg orientiert ist und wobei die Leiterstruktur (20). Anschlusspads (21, 21') aufweist, die von mindestens einer Metallisierung (30, 30') kontaktiert werden, **dadurch gekennzeichnet, dass** sich die Metallisierung (30, 30') von mindestens einem Anschlusspad (21, 21') bis zu mindestens einem elektrischen Kontakt (65, 65') der Baugruppe erstreckt.
